# EUROPEAN PATENT APPLICATION

(11) **EP 4 597 484 A1**
(43) Date of publication of application: **06.08.2025**
(21) Application number: 25151963.3
(22) Date of filing: 15.01.2025
(51) Int. Cl.: G09G 3/3266, G11C 19/28

(54) **DRIVING CIRCUIT**

(30) Priority: 31.01.2024 KR 20240015180
(71) Applicant: Samsung Display Co., Ltd., Yongin-si, Gyeonggi-do 17113 (KR)
(72) Inventor: JEONG, Keukjin, Yongin-si, Gyeonggi-do 17113 (KR); KIM, Wongyun, Yongin-si, Gyeonggi-do 17113 (KR); KANG, Min, Yongin-si, Gyeonggi-do 17113 (KR); YANG, Jihoon, Yongin-si, Gyeonggi-do 17113 (KR)
(74) Representative: Dr. Weitzel & Partner

(57) **Abstract**

A driving circuit including a plurality of stages to output gate signals to pixels, each of the stages includes: a first transistor (T11) between a first terminal (IN) and a first node (A1) and including a gate connected to a first clock terminal (CK1), wherein a start signal is input to the first terminal and a first clock signal (CLK1) is input to the first clock terminal; a second transistor (T12) between the first node and a second node (Q1) and including a gate connected to the first clock terminal; a third transistor (T13) between a second clock terminal (CK2) and the first node, wherein a second clock signal (CLK2) is input to the second clock terminal; a pull-up transistor (T15) between a second terminal (V1) and an output terminal (OUT); and a pull-down (T16) transistor between the output terminal and the second clock terminal.

## Description

### 1. Technical Field

One or more embodiments of the present invention relate to a display apparatus, and more particularly, to a driving circuit that outputs gate signals and a display apparatus including the driving circuit.

### 2. Description of the Related Art

A display apparatus includes a pixel area including a plurality of pixels, a gate driving circuit, a data driving circuit, a controller, and other components. The gate driving circuit includes a plurality of stages connected to a plurality of gate lines. These stages are configured to supply gate signals to the gate lines connected to the stages based on signals from the controller.

### SUMMARY

One or more embodiments of the present invention include a small-sized gate driving circuit that can stably output gate signals and a display apparatus including the gate driving circuit. The present invention is defined by the features of the independent claims. The dependent claims describe preferred embodiments.

According to an embodiment of the present invention, there is provided a driving circuit including a plurality of stages configured to output gate signals to pixels, wherein each of the plurality of stages includes: a first transistor connected between a first terminal and a first node and including a gate connected to a first clock terminal, wherein a start signal is input to the first terminal and a first clock signal is input to the first clock terminal; a second transistor connected between the first node and a second node and including a gate connected to the first clock terminal; a third transistor connected between a second clock terminal and the first node and including a gate connected to the first terminal, wherein a second clock signal is input to the second clock terminal; a pull-up transistor connected between a second terminal and an output terminal and including a gate connected to the first clock terminal, wherein a first-level voltage is supplied to the second terminal; and a pull-down transistor connected between the output terminal and the second clock terminal and including a gate connected to the second node.

According to a preferred embodiment of the invention, the start signal includes an external signal or a gate signal that is output from a previous stage.

According to a preferred embodiment of the invention, each of the first transistor and the second transistor is a P-type transistor, and the third transistor is an N-type transistor.

According to a preferred embodiment of the invention, each of the plurality of stages further includes: a first capacitor connected between the second node and a third terminal, wherein a second-level voltage lower than the first-level voltage is supplied to the third terminal; and a second capacitor connected between the second node and the output terminal.

According to a preferred embodiment of the invention, the second clock signal is shifted by half a cycle relative to the first clock signal.

According to an embodiment of the present invention, there is provided a driving circuit including a plurality of stages configured to output gate signals to pixels, wherein each of the plurality of stages includes: a first transistor connected between a first terminal and a first node and including a gate connected to a first clock terminal, wherein a start signal is input to the first terminal and a first clock signal is input to the first clock terminal; a second transistor connected between the first node and a second node and including a gate connected to the first clock terminal; a third transistor connected between a second clock terminal and the first node and including a gate connected to the first clock terminal, wherein a second clock signal is input to a second clock terminal; a fourth transistor connected between the first node and a third node and including a gate connected to the second clock terminal; a pull-up transistor connected between a second terminal and an output terminal and including a gate connected to the third node, wherein a first-level voltage is supplied to the second terminal; and a pull-down transistor connected between the output terminal and the second clock terminal and including a gate connected to the second node.

According to a preferred embodiment of the invention, the start signal includes an external signal or a gate signal that is output from a previous stage.

According to a preferred embodiment of the invention, each of the first transistor and the second transistor is a P-type transistor, and each of the third transistor and the fourth transistor is an N-type transistor.

According to a preferred embodiment of the invention, each of the plurality of stages further includes a first capacitor connected between the second node and a third terminal, wherein a second-level voltage lower than the first-level voltage is supplied to the third terminal.

According to a preferred embodiment of the invention, each of the plurality of stages further includes: a second capacitor connected between the third node and the second terminal; and a third capacitor connected between the second node and the output terminal.

According to a preferred embodiment of the invention, the second clock signal is shifted by half a cycle relative to the first clock signal.

According to an embodiment of the present invention, there is provided a driving circuit including a plurality of stages configured to output gate signals to pixels, wherein each of the plurality of stages includes: a first transistor connected between a first terminal and a first node and including a gate connected to a first clock terminal, wherein a start signal is input to the first terminal and a first clock signal is input to the first clock terminal; a second transistor connected between the first node and a second node and including a gate connected to the first clock terminal; a third transistor connected between a second clock terminal and the first node and including a gate connected to the first terminal, wherein a second clock signal is input to the second clock terminal; and a pull-down transistor connected between an output terminal and the second clock terminal and including a gate connected to the second node, wherein, when a voltage level at the output terminal changes from a first-level voltage to a second-level voltage lower than the first-level voltage and a voltage level at the second node changes from the second-level voltage to a third-level voltage lower than the second-level voltage, the third transistor is configured to transmit the second clock signal having the second-level voltage to the first node.

According to a preferred embodiment of the invention, each of the first transistor and the second transistor is a P-type transistor, and the third transistor is an N-type transistor.

According to a preferred embodiment of the invention, each of the plurality of stages further includes: a pull-up transistor connected between a second terminal and the output terminal and including a gate connected to the first clock terminal, wherein the first-level voltage is supplied to the second terminal; a first capacitor connected between the second node and a third terminal, wherein the second-level voltage is supplied to the third terminal; and a second capacitor connected between the second node and the output terminal.

According to a preferred embodiment of the invention, the second clock signal is shifted by half a cycle relative to the first clock signal.

According to an embodiment of the present invention, there is provided a driving circuit including a plurality of stages configured to output gate signals to pixels, wherein each of the plurality of stages includes: a first transistor connected between a first terminal and a first node and including a gate connected to a first clock terminal, wherein a start signal is input to the first terminal and a first clock signal is input to the first clock terminal; a second transistor connected between the first node and a second node and including a gate connected to the first clock terminal; a third transistor connected between a second clock terminal and the first node and including a gate connected to the first clock terminal, wherein a second clock signal is input to the second clock terminal; a fourth transistor connected between the first node and a third node and including a gate connected to the second clock terminal; and a pull-down transistor connected between an output terminal and the second clock terminal and including a gate connected to the second node, wherein, when a voltage level at the output terminal changes from a first-level voltage to a second-level voltage lower than the first-level voltage and a voltage level at the second node changes from the second-level voltage to a third-level voltage lower than the second-level voltage, the third transistor is configured to transmit the second clock signal having the second-level voltage to the first node.

According to a preferred embodiment of the invention, each of the first transistor and the second transistor is a P-type transistor, and each of the third transistor and the fourth transistor is an N-type transistor.

According to a preferred embodiment of the invention, each of the plurality of stages further includes: a pull-up transistor connected between a second terminal and the output terminal and including a gate connected to the third node, wherein the first-level voltage is supplied to the second terminal; a first capacitor connected between the second node and a third terminal, wherein the second-level voltage is supplied to the third terminal; a second capacitor connected between the third node and the second terminal; and a third capacitor connected between the second node and the output terminal.

According to a preferred embodiment of the invention, the second clock signal is shifted by half a cycle relative to the first clock signal.

According to an embodiment of the present invention, there is provided a driving circuit including a plurality of stages configured to output gate signals to pixels, wherein each of the plurality of stages includes: a first transistor connected between a first clock terminal and a second node and including a gate connected to a first terminal, wherein a first clock signal is input to the first clock terminal and a start signal is input to the first terminal; a second transistor connected between a first node and a second clock terminal or a second terminal, the second transistor including a gate connected to the first clock terminal, wherein a second clock signal is input to the second clock terminal and a first-level voltage is input to the second terminal; a third transistor connected between the first node and the second node and including a gate connected to the first terminal; a pull-up transistor connected between the second terminal and an output terminal and including a gate connected to the first clock terminal; and a pull-down transistor connected between the output terminal and the second clock terminal and including a gate connected to the second node.

According to a preferred embodiment of the invention, the start signal includes an external signal or a gate signal that is output from a previous stage.

According to a preferred embodiment of the invention, each of the first transistor and the second transistor is a P-type transistor, and the third transistor is an N-type transistor.

According to a preferred embodiment of the invention, each of the plurality of stages further includes a capacitor connected between the second node and the output terminal.

According to a preferred embodiment of the invention, the second clock signal is shifted by half a cycle relative to the first clock signal.

According to an embodiment of the present invention, there is provided a driving circuit including a plurality of stages configured to output gate signals to pixels, wherein each of the plurality of stages comprises: a first transistor connected between a first terminal and a first node and comprising a gate connected to a first clock terminal, wherein a start signal is input to the first terminal and a first clock signal is input to the first clock terminal; a second transistor connected between the first node and a second node and comprising a gate connected to the first clock terminal; a third transistor connected between a second clock terminal and the first node and configured to transmit a second clock signal to the first node., wherein a second clock signal is input to the second clock terminal; and a pull-down transistor connected between an output terminal and the second clock terminal and comprising a gate connected to the second node, wherein, when a voltage level at the output terminal changes from a first-level voltage to a second-level voltage lower than the first-level voltage and a voltage level at the second node changes from the second-level voltage to a third-level voltage lower than the second-level voltage, the third transistor is configured to transmit the second clock signal having the second-level voltage to the first node.

According to a preferred embodiment of the invention, the third transistor comprises a gate connected to the first clock terminal.

According to a preferred embodiment of the invention, each of the plurality of stages further comprises: a fourth transistor connected between the first node and a third node and comprising a gate connected to the second clock terminal; and a pull-up transistor connected between a second terminal and the output terminal and comprising a gate connected to the third node, wherein the first-level voltage is supplied to the second terminal.

According to a preferred embodiment of the invention, each of the plurality of stages further comprises: a first capacitor connected between the second node and a third terminal, wherein the second-level voltage lower than the first-level voltage is supplied to the third terminal.

According to a preferred embodiment of the invention, each of the plurality of stages further comprises: a second capacitor connected between the third node and the second terminal; and a third capacitor connected between the second node and the output terminal.

According to a preferred embodiment of the invention, the third transistor comprises a gate connected to the first terminal.

According to a preferred embodiment of the invention, each of the plurality of stages further comprises: a pull-up transistor connected between a second terminal and the output terminal and comprising a gate connected to the first clock terminal, wherein a first-level voltage is supplied to the second terminal.

According to a preferred embodiment of the invention, each of the plurality of stages further comprises: a first capacitor connected between the second node and a third terminal, wherein the second-level voltage lower than the first-level voltage is supplied to the third terminal.

According to a preferred embodiment of the invention, each of the plurality of stages further comprises: a second capacitor connected between the second node and the output terminal.

According to a preferred embodiment of the invention, the start signal comprises an external signal or a gate signal that is output from a previous stage.

According to a preferred embodiment of the invention, each of the first transistor and the second transistor is a P-type transistor, and the third transistor is an N-type transistor.

According to a preferred embodiment of the invention, the second clock signal is shifted by half a cycle relative to the first clock signal.

### BRIEF DESCRIPTION OF THE DRAWINGS

The above and other features of certain embodiments of this invention will become more apparent from the following description taken in conjunction with the accompanying drawings, in which:
FIG. 1 schematically shows a display apparatus according to an embodiment of the invention;
FIG. 2 schematically shows a driving circuit according to an embodiment of the invention;
FIG. 3 schematically shows input/output signals of a driving circuit, according to an embodiment of the invention;
FIG. 4 is a circuit diagram of an example of a stage included in the driving circuit of FIG. 2;
FIG. 5 is a timing diagram for explaining an operation of the stage of FIG. 4;
FIG. 6 is a circuit diagram of an example of a stage included in the driving circuit of FIG. 2;
FIG. 7 is a timing diagram for explaining an operation of the stage of FIG. 6;
FIG. 8 schematically shows a driving circuit according to an embodiment of the invention;
FIG. 9 is a circuit diagram of an example of a stage included in the driving circuit of FIG. 8;
FIG. 10 is a timing diagram for explaining an operation of the stage of FIG. 8; and
FIGS. 11 and 12 are circuit diagrams of an example of a stage included in the driving circuit of FIG. 8.

### DETAILED DESCRIPTION OF THE EMBODIMENTS

Detailed reference will now be made to various embodiments, examples of which are illustrated in the accompanying drawings. Like reference numerals in the drawings refer to like elements throughout. The present embodiments may have different forms and should not be construed as limited to the descriptions set forth herein. The term "and/or" as used herein includes any and all combinations of one or more of the associated listed items. The expression "at least one of a, b, or c" indicates one or more of the following: only a, only b, only c, both a and b, both a and c, both b and c, all of a, b, and c, or any combination thereof.

Given the potential for various changes and numerous embodiments, particular embodiments are shown in the drawings and described in detail in the written description. The attached drawings illustrate embodiments of the invention to provide a sufficient understanding of the present invention, its merits, and the objectives achieved by its implementation. The invention may, however, be embodied in many different forms and should not be construed as being limited to the embodiments set forth herein.

It will be understood that although terms like "first," "second," etc., may be used herein to describe various elements, these elements should not be limited by these terms. These terms are only used to distinguish one element from another.

As used herein, the singular forms "a," "an," and "the" are intended to include the plural forms as well, unless the context clearly indicates otherwise.

It will be further understood that the terms "comprises" and/or "comprising" used herein specify the presence of stated features or elements, but do not preclude the presence or addition of one or more other features or elements.

It will be understood that when a layer, region, or element is referred to as being "formed on" another layer, region, or element, it can be directly or indirectly formed on the other layer, region, or element. This means, for example, that intervening layers, regions, or elements may be present.

The sizes of elements in the drawings may be exaggerated for explanation purposes. In other words, since the sizes and thicknesses of elements depicted in the drawings are not considered to be limiting.

In the present disclosure, expressions such as "A and/or B" indicate A, B, or A and B. Additionally, expressions such as "at least one of A and B" indicate A, B, or A and B.

It will be understood that when X is referred to as being connected to Y, X may be electrically, functionally, or physically connected to Y. In addition, X may be directly connected to Y or there may be intervening components between X and Y. Here, X and Y may each be an element (e.g., an apparatus, a device, a circuit, a wire, an electrode, a terminal, a conductive layer, a layer, a region, or the like).

For example, when an electrical connection between X and Y is established, X may be directly and electrically connected to Y, and/or other components may be interposed between X and Y for an indirect electrical connection. When X is indirectly and electrically connected to Y, there may be, for example, at least one device (e.g., a switch, a transistor, a capacitive device, an inductor, a resistor, or a diode) between X and Y to facilitate the electrical connection. Therefore, the connection relationship between X and Y is not limited to a specific type, such as those illustrated in the drawings or described in detail, but may include other types of connections.

In the embodiments below, the term "on" used in relation to a device state may indicate an active state of a device, and "off" may indicate an inactive state. The term "on" regarding a signal received by a device may refer to a signal that activates the device, and "off" may refer to a signal that deactivates it. A device may be activated by either high-level voltage or low-level voltage. For example, a P-type transistor (a P-channel transistor) is activated by low-level voltage, and an N-type transistor (an N-channel transistor) is activated by high-level voltage. Therefore, "on" voltages for the P-type transistor and the N-type transistor are at opposite voltage levels (low vs. high). In this context, the voltage that activates (turns on) a transistor is called the gate-on voltage, and the voltage that deactivates (turns off) a transistor is called the gate-off voltage.

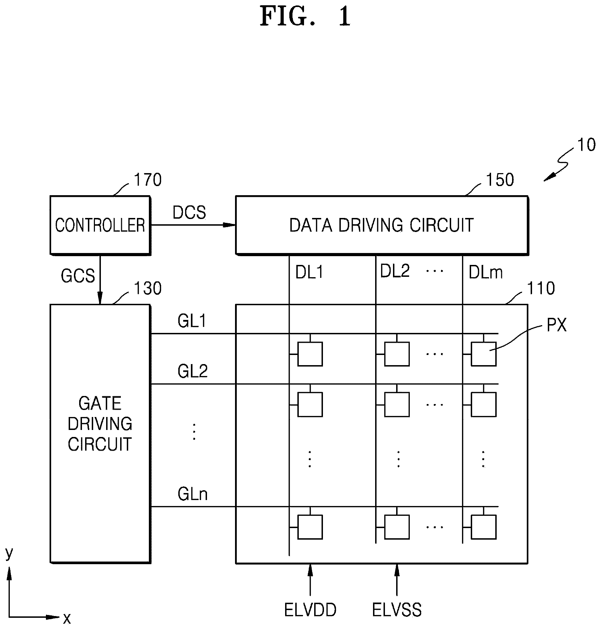

FIG. 1 schematically shows a display apparatus according to an embodiment.

A display apparatus 10 according to an embodiment may be a display apparatus, such as an organic light-emitting display apparatus, an inorganic light-emitting display apparatus (or an inorganic EL display apparatus), or a quantum dot light-emitting display apparatus.

Referring to FIG. 1, the display apparatus 10 may include a pixel area 110, a gate driving circuit 130, a data driving circuit 150, and a controller 170.

In the pixel area 110, a plurality of pixels PX and a plurality of signal lines that apply electrical signals to the pixels PX may be arranged. The pixel area 110 may correspond to a display area where images are displayed. In a peripheral area (a non-display area) outside the display area, various conductive lines transmit electrical signals to the display area. Additionally, outer driving circuits electrically connected to pixel circuits, and pads for attaching a printed circuit board or a driver IC chip, may be located in the peripheral area. For example, in the peripheral area, the gate driving circuit 130, the data driving circuit 150, and the controller 170 may be arranged.

The pixels PX may be arranged repeatedly in a first direction (x direction, row direction) and a second direction (y direction, column direction). The pixels PX may be arranged in various patterns, such as stripe, PENTILE^{®}, diamond, and mosaic forms to display images. Each pixel PX may include an organic light-emitting diode as a display element, and the organic light-emitting diode may be connected to a pixel circuit. The pixel circuit may include a plurality of transistors and at least one capacitor.

In an embodiment, the transistors included in the pixel area 110 may each be a P-type silicon transistor. The silicon transistor may include a silicon semiconductor and the silicon semiconductor may include amorphous silicon, polysilicon, or the like. For example, the silicon transistor may be a low-temperature polycrystalline silicon (LTPS) thin-film transistor.

In another embodiment, the transistors included in the pixel circuit may each be an N-type oxide transistor. The oxide transistor may include an oxide semiconductor, and the oxide semiconductor may include a Zn-oxide-based material, for example, Zn oxide, In-Zn oxide, or Ga-In-Zn oxide. In some embodiments, the oxide semiconductor may be an In-Ga-Zn-O (IGZO) semiconductor. In some embodiments, the oxide semiconductor may be an In-Sn-Ga-Zn-O (ITGZO) semiconductor. For example, the oxide transistor may be a low temperature polycrystalline oxide (LTPO) thin-film transistor. In another embodiment, some of the transistors included in the pixel circuit may be P-type silicon transistors, while others may be N-type oxide transistors.

Signal lines configured to input electrical signals to the pixels PX may include a plurality of gate lines GL1 to GLn (n is a positive integer) extending in a first direction and a plurality of data lines DL1 to DLm (m is a positive integer) extending in a second direction. The gate lines GL1 to GLn may be spaced apart from each other in the second direction and configured to transmit gate signals to the pixels PX. The data lines DL1 to DLm may be spaced apart from each other in the first direction and configured to transmit data signals to the pixels PX. Each pixel PX may be connected to at least one corresponding gate line among the gate lines GL1 to GLn and a corresponding data line among the data lines DL1 to DLm. While a gate signal is provided to the pixel PX through a corresponding gate line, the pixel PX may receive a data signal through a data line.

The gate driving circuit 130 may be connected to the gate lines GL1 to GLn, generate gate signals based on a gate driving control signal GCS from the controller 170, and sequentially provide these gate signals to the gate lines GL1 to GLn. The gate lines GL1 to GLn may be connected to gates of the transistors included in the pixels PX. The gate signals act as gate control signals to turn the transistors on and off. A gate signal may include a gate-on voltage, which turns a transistor on, and a gate-off voltage, which turns a transistor off.

The gate driving circuit 130 may include a shift register that sequentially generates and outputs the gate signals.

The data driving circuit 150 may be connected to the data lines DL1 to DLm and provide the data signals to the data lines DL1 to DLm, based on a data driving control signal DCS from the controller 170. The data signals provided through the data lines DL1 to DLm may be provided to the pixels PX that receive the gate signals.

When the display apparatus is an organic light-emitting display apparatus, a first power voltage ELVDD and a second power voltage ELVSS may be provided to the pixels PX in the pixel area 110. The first power voltage ELVDD may be a high-level voltage provided to a terminal of a driving transistor connected to a first electrode (pixel electrode or anode) of the organic light-emitting diode in each pixel PX. The second power voltage ELVSS may be a low-level voltage provided to a second electrode (opposite electrode or cathode) of an organic light-emitting diode connected to the other terminal of the driving transistor. The first power voltage ELVDD and the second power voltage ELVSS serve as driving voltages for emitting the pixels PX.

The controller 170 may generate the gate driving control signal GCS and the data driving control signal DCS, based on signals that are input from the outside (e.g., external sources). The controller 170 may provide the gate driving control signal GCS to the gate driving circuit 130 and the data driving control signal DCS to the data driving circuit 150.

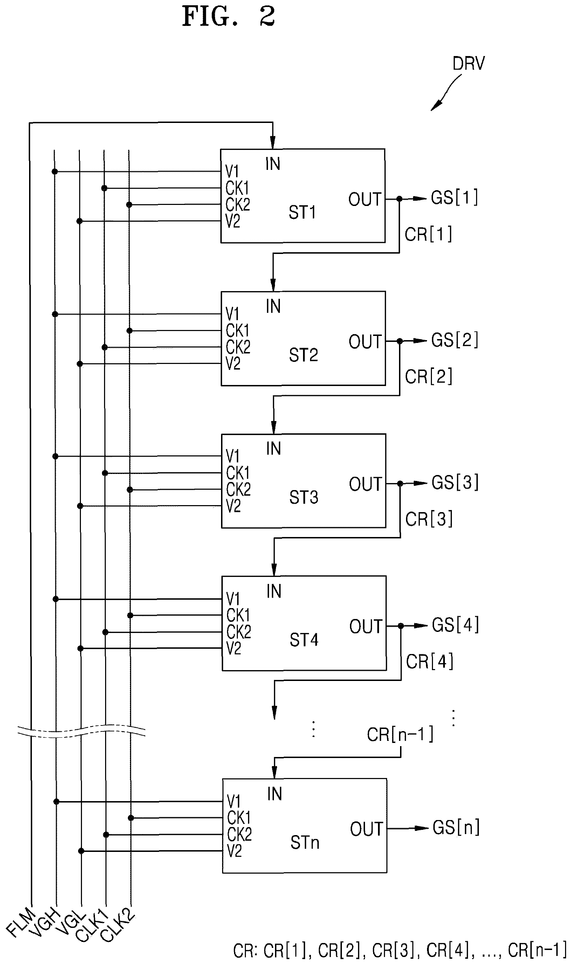

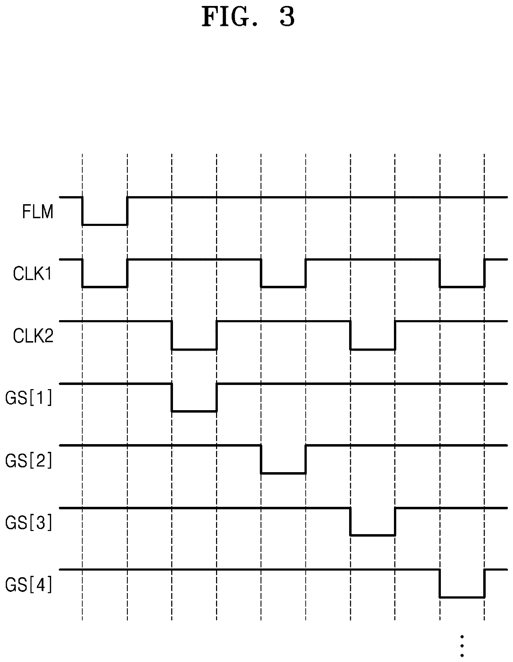

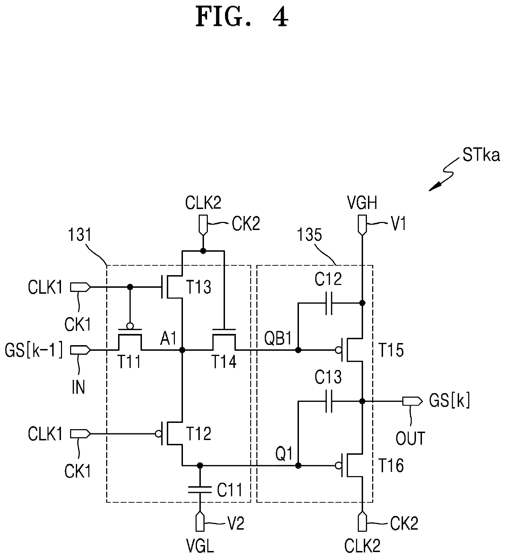

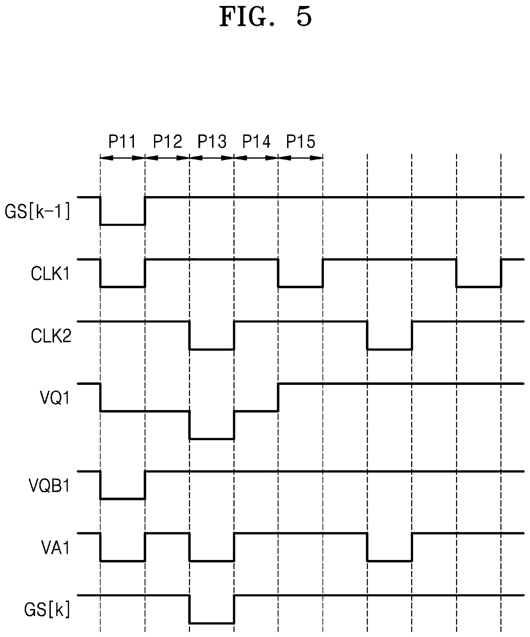

FIG. 2 schematically shows a driving circuit according to an embodiment. FIG. 3 schematically shows input/output signals of the driving circuit, according to an embodiment. FIG. 4 is a circuit diagram of an example of a stage included in the driving circuit of FIG. 2. FIG. 5 is a timing diagram for explaining the operation of the stage of FIG. 4.

A driving circuit DRV of FIG. 2 may be applied to the gate driving circuit 130 of FIG. 1. Referring to FIG. 2, the driving circuit DRV may include a plurality of stages ST1 to STn. The stages ST1 to STn may sequentially output gate signals GS[1] to GS[n] to the gate lines. The number of stages included in the driving circuit DRV may vary depending on the number of rows (horizontal lines) included in the pixel area 110.

Each of the stages ST1 to STn may be connected to a gate line corresponding to its row in the pixel area 110. Each of the stages ST1 to STn may receive at least one clock signal and at least one voltage signal to generate a gate signal GS. The generated gate signal GS is then output to a connected gate line GL. In other words, each of the stages ST1 to STn may provide the gate signal GS to the gate line GL in its corresponding row.

The stages ST1 to STn may respectively output gate signals GS[1], GS[2], GS[3], GS[4], ..., and GS[n] in response to start signals. For example, the n^{th} stage STn may output the n^{th} gate signal GS[n] to the n^{th} gate line. An external signal FLM, which is a start signal for controlling the timing of the first gate signal GS[1], may be provided to the first stage ST1.

The stages ST1 to STn may each include a plurality of terminals to which a plurality of signals are input. The signals may include a clock signal and a voltage signal. The terminals may include an input terminal IN, a first voltage input terminal V1, a second voltage input terminal V2, a first clock terminal CK1, a second clock terminal CK2, and an output terminal OUT.

A start signal may be input (provided) to the input terminal IN. The start signal may be an external signal FLM or a carry signal CR[1], CR[2], CR[3], CR[4], ..., or CR[n-1]. In an embodiment, the carry signal CR[1], CR[2], CR[3], CR[4], ..., orCR[n-1] may be a gate signal (hereinafter, referred to as a 'previous gate signal) output from a previous stage. The external signal FLM may be input to the input terminal IN of the first stage ST1 as a start signal, and previous gate signals may be respectively input to the input terminals IN of the second stage ST2 to the n^{th} stage STn as start signals. The previous stage may be a stage located at least one position prior to the current stage. FIG. 2 illustrates an example in which the previous stage is located immediately before the current stage. For example, a third gate signal GS[3] that is output from the third stage ST3 may be input to the input terminal IN of the fourth stage ST4 as a carry signal. As another example, the second stage ST2 may receive the first gate signal GS[1] at its input terminal IN.

A first voltage VGH may be input to the first voltage input terminal V1 and a second voltage VGL may be input to the second voltage input terminal V2. The second voltage VGL may have a lower voltage level than the first voltage VGH. As global signals, the first voltage VGH and the second voltage VGL may be input from the controller 170 of FIG. 1 and/or a power supply circuit.

A first clock signal CLK1 or a second clock signal CLK2 may be input to a first clock terminal CK1 and a second clock terminal CK2. The first clock signal CLK1 and the second clock signal CLK2 may be alternately input to the first clock terminals CK1 of the stages ST1 to STn. The second clock signal CLK2 and the first clock signal CLK1 may be alternately input to the second clock terminals CK2 of the stages ST1 to STn. For example, the first clock signals CLK1 and the second clock signals CLK2 may be respectively input to the first clock terminals CK1 and the second clock terminals CK2 of odd-numbered stages ST1, ST3, ... Additionally, the second clock signals CLK2 and the first clock signals CLK1 may be respectively input to the first clock terminals CK1 and the second clock terminals CK2 of even-numbered stages ST2, ST4, ...

As illustrated in FIG. 3, the first clock signal CLK1 and the second clock signal CLK2 may each be a square-wave signal that alternates between a high-level voltage and a low-level voltage. In an embodiment, the first clock signal CLK1 and the second clock signal CLK2 may each be a square-wave signal that alternates between the first voltage VGH and the second voltage VGL. The first clock signal CLK1 and the second clock signal CLK2 may have the same waveforms but with shifted phases. For example, the second clock signal CLK2 may have the same waveform as the first clock signal CLK1 but be phase-shifted at certain intervals (phase lag) when input. For example, the second clock signal CLK2 may be shifted by half a cycle relative to the first clock signal CLK1. One cycle of each of the first clock signal CLK1 and the second clock signal CLK2 may be approximately 2H (2 horizontal time).

As illustrated in FIG. 3, in both the first clock signal CLK1 and the second clock signal CLK2, the period during which high-level voltages are maintained in a single cycle may be longer than the period during which low-level voltages are maintained. However, one or more embodiments are not limited thereto. For example, in some cases, the period during which high-level voltages are maintained in a single cycle may be the same as the period during which low-level voltages are maintained.

A gate signal may be output from the output terminal OUT (see in FIG. 2). As illustrated in FIG. 3, the gate signals GS[1], GS[2], GS[3], GS[4], ..., and GS[n], which are output from the output terminals OUT of the stages ST1 to STn, may be sequentially shifted for a specific period. Each gate signal may be provided to a pixel through its corresponding output line, for example, a gate line. In an embodiment, the high-level voltages and the low-level voltages at the gate signals GS[1], GS[2], GS[3], GS[4], ..., and GS[n] may correspond to the first voltage VGH and the second voltage VGL, respectively.

In an embodiment, the low-level voltages at the gate signals GS[1], GS[2], GS[3], GS[4], ..., and GS[n] may be voltages to turn on the P-type transistors in the pixel circuit. The stages ST1 to STn may respectively output the gate signals GS[1], GS[2], GS[3], GS[4], ..., and GS[n] at low-level voltages during a 1/2 horizontal period 1/2H. The gate signals GS[1], GS[2], GS[3], GS[4], ..., and GS[n] at low-level voltages may be shifted by 1H and sequentially output. The gate signals GS[1], GS[2], GS[3], GS[4], ..., and GS[n] at low-level voltages may be shifted by 1H from the start signal and then sequentially output.

Hereinafter, the k^{th} stage (where k is a positive integer greater than or equal to 1 and less than or equal to n) corresponding to the k^{th} row of the pixel area 110 is illustratively described. The k^{th} stage may receive, as a start signal, a (k-1)^{th} gate signal GS[k-1] from the (k-1)^{th} stage that is the previous stage, output the k^{th} gate signal GS[k] to the k^{th} gate line, and output the k^{th} gate signal GS[k] as a carry signal to the (k+1)^{th} stage that is the next stage.

In an odd-numbered stage, the first clock terminal CK1 may receive the first clock signal CLK1 and the second clock terminal CK2 may receive the second clock signal CLK2. In an even-numbered stage, the first clock terminal CK1 may receive the second clock signal CLK2 and the second clock terminal CK2 may receive the first clock signal CLK1. Hereinafter, for convenience of explanation, the case where the k^{th} stage is the odd-numbered stage, the first clock terminal CK1 receives the first clock signal CLK1, and the second clock terminal CK2 receives the second clock signal CLK2 is described. When k equals 1, the first stage ST1 may receive the external signal FLM through the input terminal IN as the start signal.

Hereinafter, the first voltage VGH will be referred to as a high-level voltage, and the second voltage VGL will be referred to as a low-level voltage. The low level may also be described as the first voltage level, and the high level may also be described as the second voltage level.

Referring to FIG. 4, the k^{th} stage STka (hereinafter, referred to as the stage STka) may include a control circuit 131 and an output circuit 135. Each of the control circuit 131 and the output circuit 135 may include at least one transistor. At least one transistor may include an N-type transistor and/or a P-type transistor. For example, a first transistor T11, a second transistor T12, a fifth transistor T15, and a sixth transistor T16 in the stage STka may each be a P-type transistor, and a third transistor T13 and a fourth transistor T14 may each be an N-type transistor. The gate-on voltage of a P-type transistor may be the low-level voltage, and the gate-off voltage of the P-type transistor may be the high-level voltage. The gate-on voltage of an N-type transistor may be the high-level voltage, and the gate-off voltage of the N-type transistor may be the low-level voltage.

The control circuit 131 may control the voltages at a second node Q1 and a third node QB1 in response to signals that are input to the input terminal IN, the first clock terminal CK1, and the second clock terminal CK2. For example, the control circuit 131 may control the voltages at the second node Q1 and the third node QB1 in response to the start signal (e.g., the external signal (FLM of FIG. 2) or the carry signal (CR of FIG. 2)), the first clock signal CLK1, and the second clock signal CLK2. In an embodiment, the carry signal CR may be a previous gate signal GS[k-1]. The control circuit 131 may include the first transistor T11 to the fourth transistor T14 and a first capacitor C11.

The first transistor T11 may be connected between the input terminal IN and a first node A1. A gate of the first transistor T11 may be connected to the first clock terminal CK1. The first transistor T11 may be turned on when the first clock signal CLK1 input to the first clock terminal CK1 is at a low level, allowing the start signal from the input terminal IN to be transmitted to the first node A1.

The second transistor T12 may be connected between the first node A1 and the second node Q1. A gate of the second transistor T12 may be connected to the first clock terminal CK1. The second transistor T12 may be turned on when the first clock signal CLK1, input to the first clock terminal CK1, is at a low level. This allows the start signal, which has been transmitted to the first node A1 through the first transistor T11, to be further transmitted to the second node Q1.

The third transistor T13 may be connected between the second clock terminal CK2 and the first node A1. A gate of the third transistor T13 may be connected to the first clock terminal CK1. The third transistor T13 may be turned on when the first clock signal CLK1, which is input to the first clock terminal CK1, is at a high level. The third transistor T13 may transmit the second clock signal CLK2, input to the second clock terminal CK2, to the first node A1. The third transistor T13 may transmit a low-level voltage to the first node A1 when the voltage at the second node Q1 significantly drops, thereby reducing the voltage difference between the first node A1 and the second node Q1. This action by the third transistor T13, may relieve the stress on the second transistor T12, which is caused by the multi-stage voltage change at the second node Q1.

The fourth transistor T14 may be connected between the first node A1 and the third node QB1. A gate of the fourth transistor T14 may be connected to the second clock terminal CK2. The fourth transistor T14 may be turned on when the second clock signal CLK2, which is input to the second clock terminal CK2, is at a high level. The fourth transistor T14 may transmit the voltage at the first node A1 to the third node QB1.

The first capacitor C11 may be connected between the second node Q1 and the second voltage input terminal V2. A voltage drop in the second node Q1 and similar occurrences may be prevented by the first capacitor C11 when the fourth transistor T14 is turned off.

The output circuit 135 may be connected between the first voltage input terminal V1 and the second clock terminal CK2. The output circuit 135 may output the gate signal GS[k] having a high-level voltage or a low-level voltage, according to the voltage levels of the second node Q1 and the third node QB1. The output circuit 135 may include the fifth transistor T15 and the sixth transistor T16. The output circuit 135 may further include a second capacitor C12 and a third capacitor C13.

The fifth transistor T15 may be connected between the first voltage input terminal V1 and the output terminal OUT. A gate of the fifth transistor T5 may be connected to the third node QB1. The fifth transistor T15 may be a pull-up transistor configured to transmit a high-level voltage to the output terminal OUT. The fifth transistor T15 may be turned on when the voltage of the third node QB1 is at a low level. The fifth transistor T15 may transmit the first voltage VGH, which is a high-level voltage input to the first voltage input terminal V1, to the output terminal OUT.

The sixth transistor T16 may be connected between the output terminal OUT and the second clock terminal CK2. A gate of the sixth transistor T16 may be connected to the second node Q1. The sixth transistor T16 may be a pull-down transistor configured to transmit a low-level voltage to the output terminal OUT. The sixth transistor T16 may be turned on when the voltage at the second node Q1 is at a low level. The sixth transistor T16 may transmit the second clock signal CLK2, input to the second clock terminal CK2, to the output terminal OUT.

The second capacitor C12 may be connected between the third node QB1 and the first voltage input terminal V1. The voltage at the third node QB1 may be maintained by the second capacitor C12 when the fourth transistor T14 is turned off.

The third capacitor C13 may be connected between the second node Q1 and the output terminal OUT. The voltage at the second node Q1 may be maintained by the third capacitor C13 when the second transistor T12 is turned off. Due to the coupling of the third capacitor C13, the low-level voltage at the second node Q1 may be further reduced when the voltage level at the output terminal OUT transitions from high to low.

Hereinafter, with reference to FIG. 5, the operation of the stage STka of FIG. 4 is described. FIG. 5 illustrates a previous gate signal GS[k-1] as a start signal, a first clock signal CLK1, a second clock signal CLK2, a voltage VA1 at the first node A1, a voltage VQ1 at the second node Q1, a voltage VQB1 at the third node QB1, and a gate signal GS[k] as an output signal.

In the first period P11, the previous gate signal GS[k-1] having a low level may be input to the input terminal IN from a previous stage, the first clock signal CLK1 having a low level may be input to the first clock terminal CK1, and the second clock signal CLK2 having a high level may be input to the second clock terminal CK2.

Due to the first clock signal CLK1 having a low level, the first transistor T11 and the second transistor T12 may be turned on, and the third transistor T13 may be turned off. Due to the second clock signal CLK2 having a high level, the fourth transistor T14 may be turned on.

When the first transistor T11 and the second transistor T12 are on, the previous gate signal GS[k-1] having a low level may be transmitted to the second node Q1 through the first node A1. Consequently, the voltages at the first node A1 and the second node Q1 may be at low levels. Accordingly, the sixth transistor T16 may be turned on, and the second clock signal CLK2 having a high level may be transmitted to the output terminal OUT.

When the first transistor T11 and the fourth transistor T14 are on, the previous gate signal GS[k-1] having a low level may be transmitted to the third node QB1 from the first node A1. Consequently, the voltage at the third node QB1 may be at the low level. Accordingly, the fifth transistor T15 may be turned on and the first voltage VGH at the high level may be transmitted to the output terminal OUT.

Therefore, the gate signal GS[k] at a high level may be output from the output terminal OUT. A difference between the voltage at the third node QB1 and the first voltage VGH may be stored in the second capacitor C12.

In the second period P12, the previous gate signal GS[k-1] having a high level may be input to the input terminal IN, the first clock signal CLK1 having a high level may be input to the first clock terminal CK1, and the second clock signal CLK2 having a high level may be input to the second clock terminal CK2.

Due to the first clock signal CLK1 having a high level, the first transistor T11 and the second transistor T12 may be turned off, and the third transistor T13 may be turned on. Due to the second clock signal CLK2 having the high level, the fourth transistor T14 may be turned on.

When the third transistor T13 and the fourth transistor T14 are on, the second clock signal CLK2 having a high level may be transmitted to the third node QB1 from the first node A1. Consequently, the voltages at the first node A1 and the third node QB1 may be at high levels. Accordingly, the fifth transistor T15 may be turned off.

Due to the third capacitor C13 maintaining the low-level voltage at the second node Q1 in the first period P11, the sixth transistor T16 may remain on. As a result, the high-level second clock signal CLK2 may be transmitted to the output terminal OUT. Therefore, the high-level gate signal GS[k] may be output from the output terminal OUT.

In the third period P13, the previous gate signal GS[k-1] having a high level may be input to the input terminal IN, the first clock signal CLK1 having a high level may be input to the first clock terminal CK1, and the second clock signal CLK2 having a low level may be input to the second clock terminal CK2.

Since the first clock signal CLK1 is maintained at a high level, the first transistor T11 and the second transistor T12 may remain off, while the third transistor T13 may stay on. According to the low-level second clock signal CLK2, the fourth transistor T14 may be turned off.

Since the high-level voltage at the third node QB1 in the second period P12 is maintained by the second capacitor C12, the fifth transistor T15 may remain in the off state.

With the sixth transistor T16 maintaining the on state, the low level second clock signal CLK2 may be transmitted to the output terminal OUT. Therefore, the low-level gate signal GS[k] may be output from the output terminal OUT. As the voltage at the output terminal OUT drops from a high level to a low level, the voltage at the second node Q1 may decrease to a lower level than during the second period P12 due to the coupling effect of the third capacitor C13.

With the third transistor T13 that is on, the low level second clock signal CLK2 may be transmitted to the first node A1, and the voltage at the first node A1 may be the low-level voltage. Accordingly, a drastic increase in the voltage difference between the first node A1 and the second node Q1 in the third period P13 may be prevented even though the voltage at the second node Q1 drops to a lower level than during the second period P12.

In the fourth period P14, the previous gate signal GS[k-1] having a high level may be input to the input terminal IN, the first clock signal CLK1 having a high level may be input to the first clock terminal CK1, and the second clock signal CLK2 having a high level may be input to the second clock terminal CK2.

Because the first clock signal CLK1 is maintained at a high level, the first transistor T11 and the second transistor T12 may remain off, and the third transistor T13 may remain on. According to the high-level second clock signal CLK2, the fourth transistorT14 may be turned on.

When the third transistor T13 and the fourth transistor T14 are on, the second clock signal CLK2 having a high level may be transmitted to the third node QB1 from the first node A1, and the voltages at the first node A1 and the third node QB1 may be at high levels. Accordingly, the fifth transistor T15 may be turned off.

With the sixth transistor T16 maintaining the on state, the high-level second clock signal CLK2 may be transmitted to the output terminal OUT. Therefore, the high-level gate signal GS[k] may be output from the output terminal OUT. As the voltage at the output terminal OUT rises from a low level to a high level, the coupling effect of the third capacitor C13 may cause the voltage at the second node Q1 to increase to a higher low level (e.g., approximately the voltage level in the second period P12) than during the third period P13.

In the fifth period P15, the previous gate signal GS[k-1] having a high level may be input to the input terminal IN, the first clock signal CLK1 having a low level may be input to the first clock terminal CK1, and the second clock signal CLK2 having a high level may be input to the second clock terminal CK2.

According to the low-level first clock signal CLK1, the first transistor T11 and the second transistor T12 may be turned on, and the third transistor T13 may be turned off. According to the high-level second clock signal CLK2, the fourth transistor T14 may be turned on.

When the first transistor T11 and the second transistor T12 are on, the previous gate signal GS[k-1] at a high level may be transmitted to the second node Q1 from the first node A1, resulting in high voltages at the first node A1 and the second node Q1. Accordingly, the sixth transistor T16 may be turned off.

When the first transistor T11 and the fourth transistor T14 are on, the previous gate signal GS[k-1] at a high level may be transmitted to the third node QB1 from the first node A1, resulting in a high level voltage at the third node QB1. Accordingly, the fifth transistor T15 may be turned off.

Therefore, the high-level gate signal GS[k] may be output from the output terminal OUT.

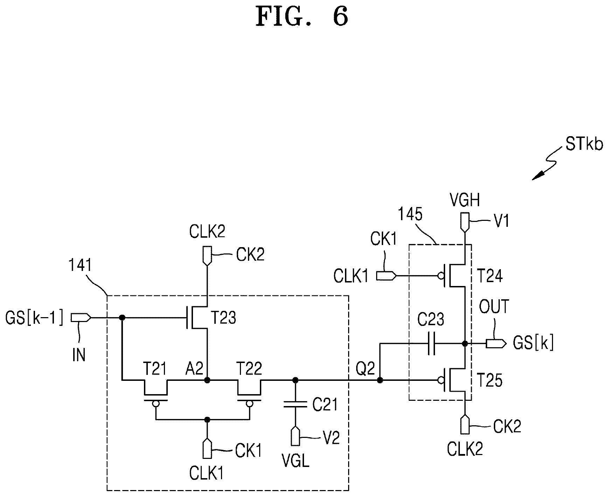

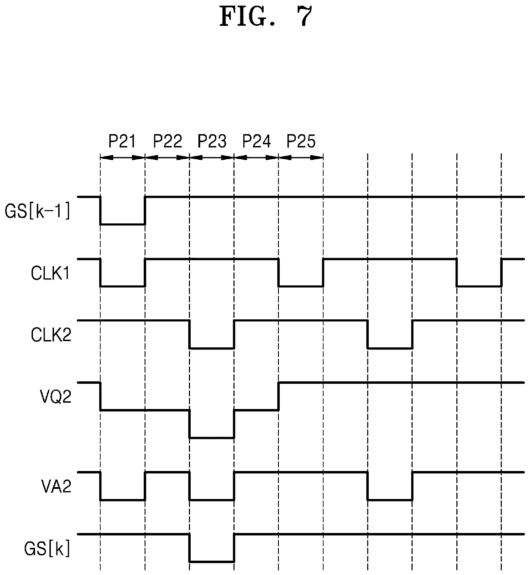

FIG. 6 is a circuit diagram of an example of a stage included in the driving circuit of FIG. 2. FIG. 7 is a timing diagram for explaining the operation of the stage of FIG. 6.

Referring to FIG. 6, the k^{th} stage STkb (hereinafter, referred to as a stage STkb) may include a control circuit 141 and an output circuit 145. Each of the control circuit 141 and the output circuit 145 may include at least one transistor. At least one transistor may include an N-type transistor and/or a P-type transistor. For example, a first transistor T21, a second transistor T22, a fourth transistor T24, and a fifth transistor T25 in the stage STkb may each be a P-type transistor, and a third transistor T23 may be an N-type transistor. The gate-on voltage of a P-type transistor may be the low-level voltage, and the gate-off voltage of the P-type transistor may be the high-level voltage. The gate-on voltage of an N-type transistor may be the high-level voltage, and the gate-off voltage of the N-type transistor may be the low-level voltage.

The control circuit 141 may control the voltage at a second node Q2 in response to signals that are input to the input terminal IN, the first clock terminal CK1, and the second clock terminal CK2. For example, the control circuit 141 may control the voltage at the second node Q2 in response to the start signal (e.g., the external signal (FLM of FIG. 2) or the carry signal (CR of FIG. 2)), the first clock signal CLK1, and the second clock signal CLK2. In an embodiment, the carry signal CR may be a previous gate signal GS[k-1]. The control circuit 141 may include the first transistor T21 to the third transistor T23 and a first capacitor C21.

The first transistor T21 may be connected between the input terminal IN and a first node A2. A gate of the first transistor T21 may be connected to the first clock terminal CK1. The first transistor T21 may be turned on when the first clock signal CLK1, which is input to the first clock terminal CK1, is at a low level. The first transistor T21 may transmit the start signal that is input to the input terminal IN, to the first node A2.

The second transistor T22 may be connected between the first node A2 and the second node Q2. A gate of the second transistor T22 may be connected to the first clock terminal CK1. The second transistor T22 may be turned on when the first clock signal CLK1, which is input to the first clock terminal CK1, is at a low level. The second transistor T22 may transmit the voltage at the first node A2 to the second node Q2.

The third transistor T23 may be connected between the second clock terminal CK2 and the first node A2. A gate of the third transistor T23 may be connected to the input terminal IN. The third transistor T23 may be turned on when the start signal, which is input to the input terminal IN, is at a high level. The third transistor T23 may transmit the second clock signal CLK2 to the first node A2. The third transistor T23 may transmit a low-level voltage to the first node A2 when the voltage at the second node Q2 significantly drops, thereby reducing the voltage difference between the first node A2 and the second node Q2. This action by the third transistor T23 may relieve stress on the second transistor T22, which is caused by the multi-stage voltage change at the second node Q2.

The first capacitor C21 may be connected between the second node Q2 and the second voltage input terminal V2. A voltage drop in the second node Q2 and similar issues may be prevented by the first capacitor C21 when the second transistor T22 is turned off.

The output circuit 145 may be connected between the first voltage input terminal V1 and the second clock terminal CK2. The output circuit 145 may output the gate signal GS[k] having a high-level voltage or a low-level voltage, according to the voltage levels of the second node Q2 and the first clock signal CLK1. The output circuit 145 may include the fourth transistor T24 and the fifth transistor T25. The output circuit 145 may further include a second capacitor C23.

The fourth transistor T24 may be connected between the first voltage input terminal V1 and the output terminal OUT. A gate of the fourth transistor T24 may be connected to the first clock terminal CK1. The fourth transistor T24 may be a pull-up transistor configured to transmit a high-level voltage to the output terminal OUT. The fourth transistor T24 may be turned on when the first clock signal CLK1, which is input to the first clock terminal CK1, is at a low level. The fourth transistor T24 may transmit the first voltage VGH, a high-level voltage input to the first voltage input terminal V1, to the output terminal OUT. A gate of the fourth transistor T24 may be directly connected to the first clock terminal CK1, thus controlling the on and off states of the fourth transistor T24 according to the first clock signal CLK1.

The fifth transistor T25 may be connected between the output terminal OUT and the second clock terminal CK2. A gate of the fifth transistor T25 may be connected to the second node Q2. The fifth transistor T25 may be a pull-down transistor configured to transmit a low-level voltage to the output terminal OUT. The fifth transistor T25 may be turned on when the voltage at the second node Q2 is at a low level. The first transistor T25 may transmit the second clock signal CLK2 input to the second clock terminal CK2, to the output terminal OUT.

The second capacitor C23 may be connected between the second node Q2 and the output terminal OUT. The voltage at the second node Q2 may be maintained by the second capacitor C23 when the second transistor T22 is turned off. Due to the coupling of the second capacitor C23, the low-level voltage at the second node Q2 may be further reduced when the voltage level at the output terminal OUT transitions from high to low.

Hereinafter, with reference to FIG. 7, the operation of the stage STkb of FIG. 6 is described. FIG. 7 illustrates the previous gate signal GS[k-1] as the start signal, the first clock signal CLK1, the second clock signal CLK2, a voltage VA2 at the first node A2, a voltage VQ2 at the second node Q2, and the gate signal GS[k] as the output signal.

In the first period P21, the previous gate signal GS[k-1] having a low level may be input to the input terminal IN from the previous stage, the first clock signal CLK1 having a low level may be input to the first clock terminal CK1, and the second clock signal CLK2 having a high level may be input to the second clock terminal CK2.

Due to the low-level first clock signal CLK1, the first transistor T21, the second transistor T22, and the fourth transistor T24 may be turned on. Due to the low-level previous gate signal GS[k-1], the third transistor T23 may be turned off.

When the fourth transistor T24 is on, the first voltage VGH at a high level, input to the first voltage input terminal V1, may be transmitted to the output terminal OUT.

When the first transistor T21 and the second transistor T22 are on, the previous gate signal GS[k-1] at a low level may be transmitted to the second node Q2 from the first node A2, resulting in low voltages at the first node A2 and the second node Q2. Accordingly, the fifth transistor T25 may be turned on, and the high level second clock signal CLK2 may be transmitted to the output terminal OUT.

Therefore, the high-level gate signal GS[k] may be output from the output terminal OUT.

In the second period P22, the previous gate signal GS[k-1] having a high level may be input to the input terminal IN, the first clock signal CLK1 having a high level may be input to the first clock terminal CK1, and the second clock signal CLK2 having a high level may be input to the second clock terminal CK2.

Due to the high-level first clock signal CLK1, the first transistor T21, the second transistor T22, and the fourth transistor T24 may be turned off. Due to the high-level previous gate signal GS[k-1], the third transistor T23 may be turned on. When the third transistor T23 is on, the high level second clock signal CLK2 may be transmitted to the first node A2.

Due to the second capacitor C23 maintaining the low-level voltage at the second node Q2 during the first period P21, the fifth transistor T25 may remain on. Consequently, the high level second clock signal CLK2 may be transmitted to the output terminal OUT. Therefore, the high-level gate signal GS[k] may be output from the output terminal OUT.

In the third period P23, the previous gate signal GS[k-1] having a high level may be input to the input terminal IN, the first clock signal CLK1 having a high level may be input to the first clock terminal CK1, and the second clock signal CLK2 having a low level may be input to the second clock terminal CK2.

Because the first clock signal CLK1 is maintained at a high level, the first transistor T21, the second transistor T22, and the fourth transistor T24 may remain in the off state. Due to the previous gate signal GS[k-1] having a high level, the third transistor T23 may be turned on.

With the fifth transistor T25 maintaining the on state, the low level second clock signal CLK2 may be transmitted to the output terminal OUT. Therefore, the low-level gate signal GS[k] may be output from the output terminal OUT. As the voltage at the output terminal OUT drops from a high level to a low level, the coupling effect of the second capacitor C23 may cause the voltage at the second node Q2 to drop to a lower level than during the second period P22.

With the third transistor T23 in the on state, the low level second clock signal CLK2 may be transmitted to the first node A2, resulting in a low level voltage at the first node A2. Accordingly, a drastic increase in the voltage difference between the first node A2 and the second node Q2 during the third period P23 may be prevented, even though the voltage at the second node Q2 drops to a voltage level lower than during the second period P22.

In the fourth period P24, the previous gate signal GS[k-1] having a high level may be input to the input terminal IN, the first clock signal CLK1 having a high level may be input to the first clock terminal CK1, and the second clock signal CLK2 having a high level may be input to the second clock terminal CK2.

Because the first clock signal CLK1 is maintained at a high level, the first transistor T21, the second transistor T22, and the fourth transistor T24 may remain in the off state.

With the fifth transistor T25 maintaining the on state, the high-level second clock signal CLK2 may be transmitted to the output terminal OUT. Therefore, the high-level gate signal GS[k] may be output from the output terminal OUT. As the voltage at the output terminal OUT rises from a low level to a high level, the voltage at the second node Q2 may increase to a low level (e.g., approximately the voltage level in the second period P22) that is higher than the voltage level in the third period P23 due to the coupling effect of the second capacitor C23.

Due to the high-level previous gate signal GS[k-1], the third transistor T23 may be turned on. When the third transistor T23 is on, the high-level second clock signal CLK2 may be transmitted to the first node A2.

In the fifth period P25, the previous gate signal GS[k-1] having a high level may be input to the input terminal IN, the first clock signal CLK1 having a low level may be input to the first clock terminal CK1, and the second clock signal CLK2 having a high level may be input to the second clock terminal CK2.

Due to the first clock signal CLK1 having a low level, the first transistor T21, the second transistor T22, and the fourth transistor T24 may be turned on.

When the first transistor T21 and the second transistor T22 are on, the previous gate signal GS[k-1] having a high level may be transmitted to the second node Q2 from the first node A2, resulting in high voltages at the first node A2 and the second node Q2. Accordingly, the fifth transistor T25 may be turned off.

When the fourth transistor T24 is on, the first voltage VGH having a high level and input to the first voltage input terminal V1 may be transmitted to the output terminal OUT. Therefore, the high-level gate signal GS[k] may be continuously output from the output terminal OUT.

The third transistor T23 may remain in the on state according to the high-level previous gate signal GS[k-1]. With the third transistor T23 in the on state, the high-level second clock signal CLK2 may be transmitted to the first node A2, resulting in a high level voltage at the first node A2.

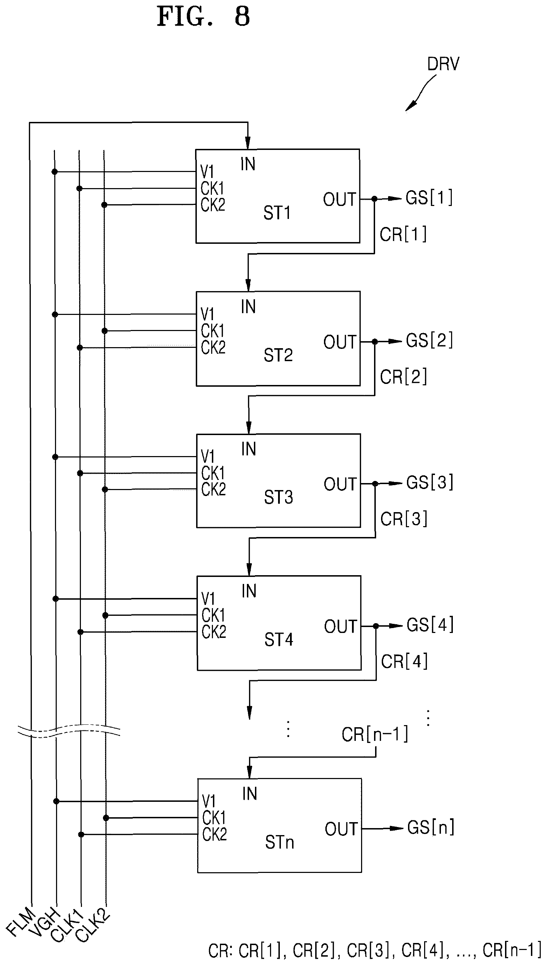

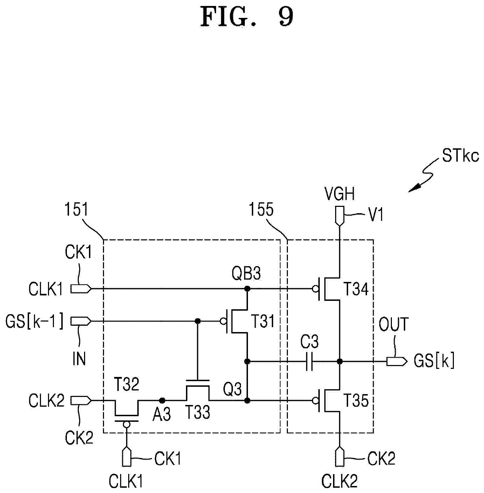

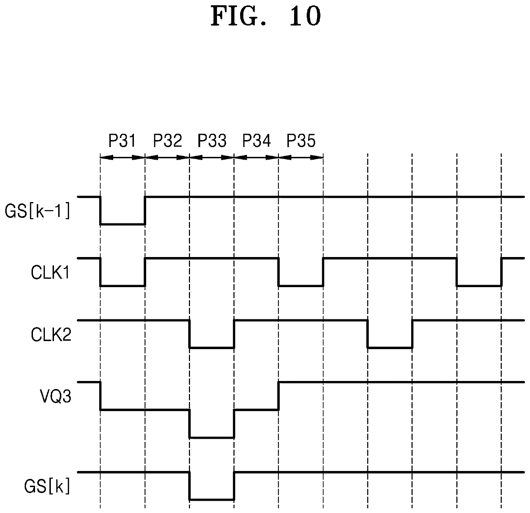

FIG. 8 schematically shows a driving circuit according to an embodiment. FIG. 9 is a circuit diagram of an example of a stage included in the driving circuit of FIG. 8. FIG. 10 is a timing diagram for explaining the operation of the stage of FIG. 8.

The driving circuit DRV of FIG. 8 may be applied to the gate driving circuit 130 of FIG. 1. Referring to FIG. 8, the driving circuit DRV may include a plurality of stages ST1 to STn. The stages ST1 to STn may sequentially output gate signals GS[1] to GS[n] to the gate lines GL1 to GLn. The driving circuit DRV of FIG. 8 is different from that of FIG. 2 in that the second voltage VGL is omitted from the signals input to the driving circuit DRV of FIG. 8 and the second voltage input terminal V2 of each of the stages ST1 to STn is omitted. Other input/output signals are the same as those illustrated in FIG. 3. The reduction in the supply voltage and voltage lines may lead to a decrease in the area of the non-display area where the driving circuit DRV is arranged.

Hereinafter, an example, in which a k^{th} stage STkc (the current stage) corresponding to a k^{th} row in the pixel area 110 is an odd-numbered stage, is described. The k^{th} stage STkc may receive, as a start signal, a (k-1)^{th} gate signal GS[k-1] from the (k-1)^{th} stage that is the previous stage, output the k^{th} gate signal GS[k] to the k^{th} gate line, and output the k^{th} gate signal GS[k] to the (k+1)^{th} stage that is the next stage. The first clock signal CLK1 may be input to the first clock terminal CK1, and the second clock signal CLK2 may be input to the second clock terminal CK2. When k equals 1, the first stage ST1 may receive the external signal FLM from the input terminal IN as the start signal.

Referring to FIG. 9, the k^{th} stage STkc may include a control circuit 151 and an output circuit 155. Each of the control circuit 151 and the output circuit 155 may include at least one transistor. At least one transistor may include an N-type transistor and/or a P-type transistor. For example, a first transistor T31, a second transistor T32, a fourth transistor T34, and a fifth transistor T35 in the k^{th} stage STkc may each be a P-type transistor, and a third transistor T33 in the k^{th} stage STkc may be an N-type transistor.

The control circuit 151 may control the voltages at a second node Q3 and a third node QB3 in response to signals that are input to the input terminal IN, the first clock terminal CK1, and the second clock terminal CK2. For example, the control circuit 151 may control the voltages at the second node Q3 and the third node QB3 in response to the start signal (e.g., the external signal (FLM of FIG. 8) or the carry signal (CR of FIG. 8)), the first clock signal CLK1, and the second clock signal CLK2. In an embodiment, the carry signal CR may be a previous gate signal GS[k-1]. The control circuit 151 may include the first transistor T31 to the third transistor T33. Hereinafter, an example in which the previous gate signal GS[k-1] is input to the input terminal IN is described.

The first transistor T31 may be connected between the third node QB3 and the second node Q3. A gate of the first transistor T31 may be connected to the input terminal IN. The first transistor T31 may be turned on when the previous gate signal GS[k-1], which is input to the input terminal IN, is at a low level. The first transistor T31 may transmit the first clock signal CLK1 that is input to the first clock terminal CK1, to the second node Q3.

The second transistor T32 may be connected between the second clock terminal CK2 and the first node A3. The first node A3 may be located between the second transistor T32 and the third transistor T33. A gate of the second transistor T32 may be connected to the first clock terminal CK1. The second transistor T32 may be turned on when the first clock signal CLK1, which is input to the first clock terminal CK1, is at a low level. The second transistor T32 may transmit the second clock signal CLK2 to the first node A3. When the low-level second clock signal CLK2 is input and the voltage at the second node Q3 drops significantly, the voltage difference between the first node A3 and the second node Q3 may be reduced, thereby relieving the stress on the second transistor T32.

The third transistor T33 may be connected between the first node A3 and the second node Q3. A gate of the third transistor T33 may be connected to the input terminal IN. The third transistor T33 may be turned on when a start signal input to the input terminal IN is at a high level. The third transistor T33 may transmit the second clock signal CLK2 that is transmitted to the first node A3, to the second node Q3.

The output circuit 155 may be connected between the first voltage input terminal V1 and the second clock terminal CK2. The output circuit 155 may output the gate signal GS[k] having a high-level voltage or a low-level voltage, according to the voltage levels of the second node Q3 and the first clock signal CLK1. The output circuit 155 may include the fourth transistor T34 and the fifth transistor T35. The output circuit 155 may further include a capacitor C3.

The fourth transistor T34 may be connected between the first voltage input terminal V1 and the output terminal OUT. A gate of the fourth transistor T34 may be connected to the first clock terminal CK1. The fourth transistor T34 may be a pull-up transistor configured to transmit a high-level voltage to the output terminal OUT. The fourth transistor T34 may be turned on when the first clock signal CLK1, which is input to the first clock terminal CK1, is at a low level. The fourth transistor T34 may transmit the first voltage VGH that is the high-level voltage input to the first voltage input terminal V1, to the output terminal OUT. A gate of the fourth transistor T34 may be directly connected to the first clock terminal CK1. Consequently, the turning on and off of the fourth transistor T34 may be controlled by the first clock signal CLK1.

The fifth transistor T35 may be connected between the output terminal OUT and the second clock terminal CK2. A gate of the fifth transistor T35 may be connected to the second node Q3. The fifth transistor T35 may be a pull-down transistor configured to transmit a low-level voltage to the output terminal OUT. The fifth transistor T35 may be turned on when the voltage at the second node Q3 is at a low level. The fifth transistor T35 may be configured to transmit the second clock signal CLK2 that is input to the second clock terminal CK2, to the output terminal OUT.

The capacitor C3 may be connected between the second node Q3 and the output terminal OUT. The voltage at the second node Q3 may be maintained by the capacitor C3 when the second transistor T32 is turned off. When the voltage level of the output terminal OUT transitions from high to low, the low-level voltage at the second node Q3 may decrease to an even lower level due to the coupling of the capacitor C3.

Hereinafter, with reference to FIG. 10, the operation of the k^{th} stage STkc of FIG. 9 is described. FIG. 10 illustrates a previous gate signal GS[k-1] as a start signal, a first clock signal CLK1, a second clock signal CLK2, a voltage VQ3 at the second node Q3, and a gate signal GS[k] as an output signal.

In the first period P31, the previous gate signal GS[k-1] having a low level may be input to the input terminal IN, the first clock signal CLK1 having a low level may be input to the first clock terminal CK1, and the second clock signal CLK2 having a high level may be input to the second clock terminal CK2.

In response to the low-level previous gate signal GS[k-1], the first transistor T31 may be turned on, and in response to the low-level first clock signal CLK1, the second transistor T32 and the fourth transistor T34 may be turned on. In response to the low-level previous gate signal GS[k-1], the third transistor T33 may be turned off.

When the fourth transistor T34 is on, the first voltage VGH having a high level and input to the first voltage input terminal V1 may be transmitted to the output terminal OUT.

Through the first transistor T31 that is on, the low-level first clock signal CLK1 may be transmitted to the second node Q3. The fifth transistor T35, which includes a gate connected to the second node Q3, is turned on, allowing the high-level second clock signal CLK2 to be transmitted to the output terminal OUT. Therefore, the high-level gate signal GS[k] may be output from the output terminal OUT. In this case, the voltage difference between the source and drain of the second transistor T32 may correspond to the difference between the high-level voltage of the second clock signal CLK2 and the low-level voltage of the first clock signal CLK1.

In the second period P32, the previous gate signal GS[k-1] having a high level may be input to the input terminal IN, the first clock signal CLK1 having a high level may be input to the first clock terminal CK1, and the second clock signal CLK2 having a high level may be input to the second clock terminal CK2.

In response to the high-level first clock signal CLK1, the second transistor T32 and the fourth transistor T34 may be turned off. In response to the high-level previous gate signal GS[k-1], the first transistor T31 may be turned off, and the third transistor T33 may be turned on.

Because the low-level voltage at the second node Q3 in the first period P31 is maintained by the capacitor C3, the fifth transistor T35 may remain on, allowing the high-level second clock signal CLK2 to be transmitted to the output terminal OUT. Therefore, the high-level gate signal GS[k] may be output from the output terminal OUT. In this case, the voltage difference between the source and drain of the second transistor T32 is the difference between the high-level voltage of the second clock signal CLK2 and the low-level voltage at the second node Q3. This voltage difference may be substantially similar to the voltage difference between the source and drain of the second transistor T32 in the first period P31.

In the third period P33, the previous gate signal GS[k-1] having a high level may be input to the input terminal IN, the first clock signal CLK1 having a high level may be input to the first clock terminal CK1, and the second clock signal CLK2 having a low level may be input to the second clock terminal CK2.

Because the first clock signal CLK1 is maintained at a high level, the second transistor T32 and the fourth transistor T34 may remain off. In response to the high-level previous gate signal GS[k-1], the first transistor T31 may remain off, and the third transistor T33 may remain on.

Because the low-level voltage at the second node Q3 in the second period P32 is maintained by the capacitor C3, the low-level second clock signal CLK2 may be transmitted to the output terminal OUT through the fifth transistor T35 that is on. Therefore, the low-level gate signal GS[k] may be output from the output terminal OUT.

As the voltage at the output terminal OUT drops from a high level to a low level, the coupling of the capacitor C3 may cause the voltage at the second node Q3 to drop to a level lower than the voltage level in the second period P32 by as much as a voltage change at the output terminal OUT. In this case, the voltage difference between the source and drain of the second transistor T32 is the difference between the low-level voltage of the second clock signal CLK2 and the low-level voltage at the second node Q3. This voltage difference may be substantially similar to the voltage difference between the source and drain of the second transistor T32 in the second period P32.

As the second transistor T32 receives the second clock signal CLK2, the drastic increase in the voltage difference between the source and drain of the second transistor T32 in the third period P33 may be prevented, even though the voltage at the second node Q3 drops to a voltage level lower than the voltage level in the second period P32.

In the fourth period P34, the previous gate signal GS[k-1] having a high level may be input to the input terminal IN, the first clock signal CLK1 having a high level may be input to the first clock terminal CK1, and the second clock signal CLK2 having a high level may be input to the second clock terminal CK2.

Because the first clock signal CLK1 is maintained at a high level, the second transistor T32 and the fourth transistor T34 may remain off. In response to the high-level previous gate signal GS[k-1], the first transistor T31 may remain off, and the third transistor T33 may remain on.

Because the low-level voltage at the second node Q3 in the second period P32 is maintained by the capacitor C3, the high-level second clock signal CLK2 may be transmitted to the output terminal OUT through the fifth transistor T35 that is on. Therefore, the high-level gate signal GS[k] may be output from the output terminal OUT. In this case, as the voltage at the output terminal OUT rises from a low level to a high level, the voltage at the second node Q3 may increase to a low level (e.g., approximately the voltage level in the second period P32), which is higher than the voltage level in the third period P33 due to the coupling of the capacitor C3.

The voltage difference between the source and drain of the second transistor T32 is the difference between the high-level voltage of the second clock signal CLK2 and the low-level voltage at the second node Q3. This voltage difference may be substantially similar to the voltage difference between the source and drain of the second transistor T32 in the second period P32.

In the fifth period P35, the previous gate signal GS[k-1] having a high level may be input to the input terminal IN, the first clock signal CLK1 having a low level may be input to the first clock terminal CK1, and the second clock signal CLK2 having a high level may be input to the second clock terminal CK2.

In response to the low-level first clock signal CLK1, the second transistor T32 and the fourth transistor T34 may be turned on. In response to the high-level previous gate signal GS[k-1], the first transistor T31 may be turned off, and the third transistor T33 may be turned on.

When the second transistor T32 and the third transistor T33 are on, the high-level second clock signal CLK2 may be transmitted to the second node Q3 through the first node A3, and the voltages at the first node A3 and the second node Q3 may be high-level voltages. Accordingly, the fifth transistor T35 may be turned off.

When the fourth transistor T34 is on, the first voltage VGH having a high level and input to the first voltage input terminal V1 may be transmitted to the output terminal OUT. Therefore, the high-level gate signal GS[k] may be output from the output terminal OUT.

The voltage difference between the source and drain of the second transistor T32 may be approximately 0 V.

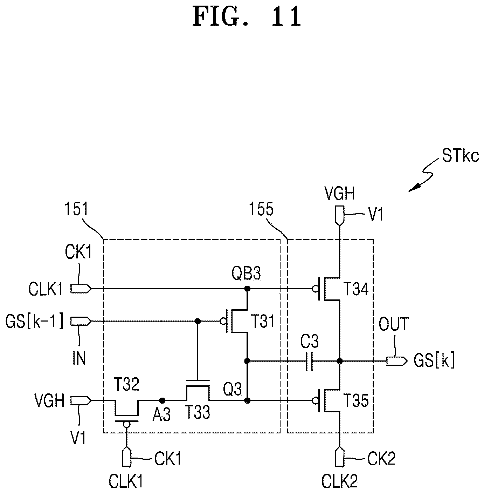

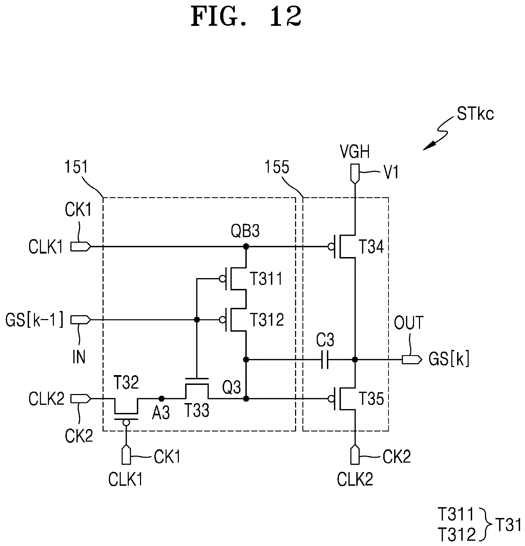

FIGS. 11 and 12 are circuit diagrams of an example of a stage included in the driving circuit of FIG. 8.

The k^{th} stage STkc of FIG. 11 is different from the k^{th} stage STkc of FIG. 9 in that the second transistor T32 is connected to the first voltage input terminal V1 and the voltage difference between the source and drain of the second transistor T32 in the third period P33 increases. Other configurations and operations are the same as those of the k^{th} stage STkc of FIG. 9.

The second transistor T32 may be connected between the first voltage input terminal V1 and the first node A3. A gate of the second transistor T32 may be connected to the first clock terminal CK1.

In the first period (P31 of FIG. 10), the second transistor T32 may be turned on in response to the low-level first clock signal CLK1, and the first transistor T31 may be turned on in response to the low-level previous gate signal GS[k-1]. The low-level first clock signal CLK1 may be transmitted to the second node Q3 through the first transistor T31 that is on, and the voltage difference between the source and drain of the second transistor T32 may be the difference between the high-level voltage of the first voltage VGH and the low-level voltage of the first clock signal CLK1.

In the second period (P32 of FIG. 10), the second transistor T32 may be turned off in response to the high-level first clock signal CLK1, and the third transistor T33 may be turned on in response to the high-level previous gate signal GS[k-1]. The voltage at the second node Q3 may be maintained at a low level in the first period P31 by the capacitor C3. As in the first period P31, the voltage difference between the source and drain of the second transistor T32 may correspond to the difference between the high-level voltage of the first voltage VGH and the low-level voltage of the first clock signal CLK1.

In the third period (P33 of FIG. 10), the second transistor T32 may remain in the off state in response to the high-level first clock signal CLK1, and the third transistor T33 may remain in the on state in response to the high-level previous gate signal GS[k-1]. The voltage at the second node Q3 may be maintained at a low level in the second period P32 by the capacitor C3.

With the fifth transistor T35 remaining in the on state, the low-level second clock signal CLK2 may be transmitted to the output terminal OUT. As the voltage at the output terminal OUT drops from a high level to a low level, the voltage at the second node Q3 may decrease to a level lower than the voltage in the second period P32 by the same amount as the voltage change at the output terminal OUT due to the coupling of the capacitor C3. In this case, the voltage difference between the source and drain of the second transistor T32 is the difference between the high-level voltage of the first voltage VGH and the low-level voltage at the second node Q3, which may be greater compared to the voltage difference between the source and drain of the second transistor T32 during the second period P32.

In the fourth period (P34 of FIG. 10), the second transistor T32 may remain in the off state in response to the high-level first clock signal CLK1, and the third transistor T33 may remain in the on state in response to the high-level previous gate signal GS[k-1]. The voltage at the second node Q3 may be maintained at a low level in the second period P32 by the capacitor C3.

With the fifth transistor T35 remaining in the on state, the high-level second clock signal CLK2 may be transmitted to the output terminal OUT. As the voltage at the output terminal OUT rises from a low level to a high level, the coupling of the capacitor C3 may cause the voltage at the second node Q3 to increase to a voltage level that is higher than that in the third period P33 and approximately equal to that in the second period P32. This increase corresponds to the voltage change at the output terminal OUT. In this case, the voltage difference between the source and drain of the second transistor T32 is the difference between the high-level voltage of the first voltage VGH and the low-level voltage at the second node Q3. This voltage difference may be similar to the voltage difference between the source and drain of the second transistor T32 in the second period P32. In the fourth period P34, the voltage difference between the source and drain of the second transistor T32 may be reduced compared to the voltage difference between the source and drain of the second transistor T32 in the third period P33.

In the fifth period (P35 of FIG. 10), the second transistor T32 may be turned on in response to the low-level first clock signal CLK1, and the third transistor T33 may be turned on in response to the high-level previous gate signal GS[k-1]. When the second transistor T32 and the third transistor T33 are on, the first voltage VGH may be transmitted to the second node Q3, and the fifth transistor T35 may be turned off. In this case, the voltage difference between the source and drain of the second transistor T32 may be approximately 0 V.

The k^{th} stage STkc of FIG. 12 is different from that illustrated in FIG. 9 in that the first transistor T31 of FIG. 12 includes a plurality of sub-transistors connected in series. Other configurations and operations are the same as those of the k^{th} stage STkc of FIG. 9.

The first transistor T31 may include a first sub-transistor T311 and a second sub-transistor T312 that are connected in series. Gates of the first sub-transistor T311 and the second sub-transistor T312 may be connected to the input terminal IN. As the first transistor T31 is realized as a dual-gate transistor including two sub-transistors, the increase in the low-level voltage at the second node Q3 may be reduced by decreasing a leakage current in the first transistor T31.

According to one or more embodiments, a control method is not applied in which the voltage level at a node connected to a gate of a pull-down transistor is reversed based on the voltage level at a node connected to a gate of a pull-up transistor, or vice versa. Instead, the voltage levels at the node connected to the gate of the pull-up transistor and the node connected to the gate of the pull-down transistor may be independently controlled.

According to the one or more embodiments, the stress on the transistors (for example, the second transistor T12 of FIG. 4, the second transistor T22 of FIG. 6, and the second transistor T32 of FIGS. 9 and 12) caused by the multi-stage voltage changes at the node connected to the gate of the pull-down transistor may be reduced, allowing for stable operation of the driving circuit.

One or more embodiments provide a driving circuit with a reduced number of transistors and capacitors, as well as a display apparatus that includes the driving circuit. The configuration of the driving circuit minimizes dead space while ensuring stable output of gate signals.

One or more embodiments provide a gate driving circuit with a reduced number of circuit devices and a display apparatus that includes the gate driving circuit. The configuration of the gate driving circuit not only reduces the area of the non-display area but also ensures the stable output of gate signals.

It should be understood that embodiments described herein are presented for descriptive purposes only and not as limitations. Descriptions of features or aspects within each embodiment should be generally considered applicable to other similar features or aspects in other embodiments. While one or more embodiments have been described with reference to the figures, it will be understood by those of ordinary skill in the art that various changes in form and details may be made without departing from the scope of the invention as set forth by the following claims.

## Claims

1. A driving circuit (DRV) comprising a plurality of stages (ST1-STn) configured to output gate signals (GS1-GSn) to pixels (PX), wherein each of the plurality of stages (ST1-STn) comprises:
a first transistor (T11, T21) connected between a first terminal (IN) and a first node (A1, A2) and comprising a gate connected to a first clock terminal (CK1), wherein a start signal is input to the first terminal (IN) and a first clock signal (CLK1) is input to the first clock terminal (CK1);
a second transistor (T12, T22) connected between the first node (A2) and a second node (Q2) and comprising a gate connected to the first clock terminal (CK1);
a third transistor (T13, T23) connected between a second clock terminal (CK2) and the first node (A1, A2) and configured to transmit a second clock signal (CLK2) to the first node (A1, A2)., wherein a second clock signal (CLK2) is input to the second clock terminal (CK2); and
a pull-down transistor (T16, T25) connected between an output terminal (OUT) and the second clock terminal (CK2) and comprising a gate connected to the second node (Q1, Q2),
wherein, when a voltage level at the output terminal (OUT) changes from a first-level voltage (VGH) to a second-level voltage (VGL) lower than the first-level voltage (VGH) and a voltage level at the second node (Q1, Q2) changes from the second-level voltage (VGL) to a third-level voltage lower than the second-level voltage (VGL), the third transistor (T13, T23) is configured to transmit the second clock signal (CLK2) having the second-level voltage (VGL) to the first node (A1, A2).

2. The driving circuit (DRV) of claim 1, wherein the third transistor (T13) comprises a gate connected to the first clock terminal (CK1).

3. The driving circuit (DRV) of claim 2, wherein each of the plurality of stages (ST1-STn) further comprises
a fourth transistor (T14) connected between the first node (A1) and a third node (QB1) and comprising a gate connected to the second clock terminal (CK2); and
a pull-up transistor (T15) connected between a second terminal (V1) and the output terminal (OUT) and comprising a gate connected to the third node (QB1), wherein the first-level voltage (VGH) is supplied to the second terminal (V1).

4. The driving circuit (DRV) of claim 3, wherein each of the plurality of stages (ST1-STn) further comprises
a first capacitor (C11) connected between the second node (Q1) and a third terminal (V2), wherein the second-level voltage (VGL) lower than the first-level voltage (VGH) is supplied to the third terminal (V2).

5. The driving circuit (DRV) of at least one of claims 3 or 4, wherein each of the plurality of stages (ST1-STn) further comprises:
a second capacitor (C12) connected between the third node (QB1) and the second terminal (V1); and
a third capacitor (C13) connected between the second node (Q1) and the output terminal (OUT).

6. The driving circuit (DRV) of claim 1, wherein the third transistor (T23) comprises a gate connected to the first terminal (IN).

7. The driving circuit (DRV) of claim 6, wherein each of the plurality of stages (ST1-STn) further comprises:
a pull-up transistor (T24) connected between a second terminal (V1) and the output terminal (OUT) and comprising a gate connected to the first clock terminal (CK1), wherein a first-level voltage (VGH) is supplied to the second terminal (V1).

8. The driving circuit (DRV) of claim 7, wherein each of the plurality of stages (ST1-STn) further comprises:
a first capacitor (C21) connected between the second node (Q2) and a third terminal (V2), wherein the second-level voltage (VGL) lower than the first-level voltage (VGH) is supplied to the third terminal (V2).

9. The driving circuit (DRV) of claim 7 or 8, wherein each of the plurality of stages (ST1-STn) further comprises:
a second capacitor (C23) connected between the second node (Q2) and the output terminal (OUT).

10. The driving circuit (DRV) of at least one of claims 1 to 9, wherein the start signal comprises an external signal (FLM) or a gate signal (GS) that is output from a previous stage (ST1-STn).

11. The driving circuit (DRV) of at least one of claims 1 to 10, wherein each of the first transistor (T11, T21) and the second transistor (T12, T22) is a P-type transistor, and the third transistor (T13, T23) is an N-type transistor.

12. The driving circuit (DRV) of at least one of claims 1 to 11, wherein the second clock signal (CLK2) is shifted by half a cycle relative to the first clock signal (CLK1).
